# EUROPÄISCHE PATENTSCHRIFT

(11) **EP 0 822 739 B1**
(45) Veröffentlichungstag und Bekanntmachung des Hinweises auf die Patenterteilung: **05.11.2003**
(21) Anmeldenummer: 97113084.4
(22) Anmeldetag: 30.07.1997
(51) Int. Cl.: H05K 13/00, B65H 3/24

(54) **Automatisierte Vorrichtung zum Prüfen von Leiterplatten**
Automated apparatus for printed circuit board inspection
Appareil automatisé de test de cartes de circuit électronique

(30) Priorität: 02.08.1996 DE 19631368
(43) Veröffentlichungstag der Anmeldung: 04.02.1998
(73) Patentinhaber: atg test systems GmbH & Co. KG, 97877 Wertheim (DE)
(72) Erfinder: Prokopp, Manfred, 97877 Wertheim-Reicholzheim (DE); Geier, Rudi, 97900 Külsheim-Hundheim (DE); Mozzi, Josef, 74405 Gaildorf (DE)
(74) Vertreter: Ganahl, Bernhard

(56) Entgegenhaltungen:
- DE-B- 1 068 729
- DE-U- 7 038 781

## Beschreibung

Die Erfindung betrifft eine automatisierte Vorrichtung zum Prüfen von Leiterplatten.

Automatisierte Vorrichtungen zum Prüfen von Leiterplatten sind Prüfeinrichtungen, die in ein Transportsystem eingebunden sind, das in Stapeln vorliegende Leiterplatten vereinzelt, der Prüfeinrichtung zuführt und von der Prüfeinrichtung einer Sammeleinrichtung zuführt, in der die Leiterplatten wieder zu einem oder mehreren Stapeln zusammengesetzt werden. Derartige automatisierte Vorrichtungen zum Prüfen von Leiterplatten weisen deshalb eine Vereinzelungseinrichtung, eine Prüfeinrichtung und eine Sammeleinrichtung auf.

An der Vereinzelungseinrichtung werden die in einem Stapel zugeführten Leiterplatten vereinzelt und dann zur Prüfeinrichtung transportiert. An der Prüfeinrichtung werden die Leiterplatten getestet, wobei an sich bekannte Verbindungs- und Kurzschlußtests durchgeführt werden. Von der Prüfeinrichtung werden die getesteten Leiterplatten zu der Sammeleinrichtung weiterbefördert und dort vorzugsweise in zwei getrennten Schächten für fehlerfreie und fehlerbehaftete Leiterplatten abgelegt.

Aus der DE 34 42 123 A1 ist eine Vereinzelungseinrichtung zum Vereinzeln gestapelter Platten bekannt. Diese Vereinzelungseinrichtung weist einen schräg angeordneten, nach oben offenen Schacht auf, in dem sich ein Stapel zu vereinzelnder Leiterplatten befindet. Am unteren Ende des Schachtes ist eine Rolle parallel zu einer Seitenkante der untersten Platte im Stapel vorgesehen. Die Rolle hat eine parallel zur Seitenkante der untersten Platte verlaufende Stufe, um die Seitenkante zu erfassen und die unterste Platte aus dem Plattenstapel herauszuziehen und auf einem Plattenablagetisch mittels eines Auswurfhebels abzulegen. Bei dieser Vereinzelungseinrichtung laßt sich der Schacht kontinuierlich nachfüllen, ohne daß eine Betriebsunterbrechung notwendig ist. Nachteilig ist hierbei jedoch, daß die gesamte Last des Stapels auf der untersten Leiterplatte aufliegt. Hierdurch ist die Stapelhöhe begrenzt, da keine sehr große Last auf der untersten Leiterplatte aufliegen darf. Die Leiterplatten müssen eine Stärke aufweisen, die ein Klemmen der nicht zu vereinzelnden Leiterplatten zuläßt. Die Außenkontur der Leiterplatte muß zumindest zwei gerade, parallele Kanten aufweisen, um von der Rolle exakt erfaßt werden zu können. Zudem besteht insbesondere bei elektrischen Leiterplatten die Gefahr, daß die Leiterplatten beim Vereinzeln beschädigt werden, da die unterste Platte unter dem darüber angeordneten Stapel von Leiterplatten abgeschoben wird.

Um diese Nachteile zu vermeiden, gibt es Vereinzelungsvorrichtungen, die jeweils eine oberste Leiterplatte eines Stapels von Leiterplatten mittels eines Saugkopfes abnehmen und auf einem Transportband ablegen. Diese Art der Vereinzelung wird als "pick and place" bezeichnet.

Die oberste Leiterplatte ist hierbei völlig entlastet, und die Vereinzelung erfolgt weitestgehend unabhängig von der Außenkontur. Der Stapel von Leiterplatten befindet sich in einem vertikalen Schacht, in dem der Stapel mittels eines Stößels oder dgl. nach oben geschoben wird. Nachteilig bei dieser Vereinzelungseinrichtung ist, daß zum Nachfüllen des Schachtes der gesamte Ablauf unterbrochen werden muß, um einen neuen Stapel in den Schacht einzuführen und den Stößel wieder nach unten in seine Ausgangsstellung zu bewegen.

Der Erfindung liegt die Aufgabe zugrunde, eine einfache und kostengünstige automatisierte Vorrichtung zum Prüfen von Leiterplatten zu schaffen, die kontinuierlich betrieben werden kann.

Die Aufgabe wird durch eine Vorrichtung mit den Merkmalen des Anspruchs 1 bzw. mit den Merkmalen des Anspruchs 15 gelöst. Vorteilhafte Ausgestaltungen der Erfindung sind in den Unteransprüchen angegeben.

Bei der Lösung nach Anspruch 1 wird eine Vereinzelungseinrichtung mit einem Schacht vorgesehen, der als eine Art Paternoster-Lift ausgebildet ist. Dieser Schacht weist zumindest zwei Sätze vertikal verfahrbarer Auflageelemente zur Aufnahme jeweils eines Stapels von Leiterplatten auf und ist zumindest an einer Seite offen, so daß der Schacht bzw. die Auflageelemente seitlich mit einem Stapel von Leiterplatten beladen werden können. Zum Abnehmen der jeweils obersten Leiterplatte des obersten Stapels von Leiterplatten ist eine Leiterplattenabnahmeeinrichtung, wie z.B. eine an sich bekannte pick-and-place-Einrichtung, vorgesehen.

Im Betrieb werden die den obersten Stapel tragenden Auflageelemente angehoben, um die Oberkante des Stapels auf konstanter Höhe zu halten und den Abtransport durch die Abnahmeeinrichtung auszugleichen. Ist der oberste Stapel von der Leiterplattenabnahmeeinrichtung vollständig abgetragen worden, wird ein darunter auf einem weiteren Satz von Auflageelementen lagernder Stapel von Leiterplatten durch eine schnelle Aufwärtsbewegung nach oben in Abnahmeposition befördert, so daß die Leiterplattenabnahmeeinrichtung kontinuierlich Leiterplatten aus dem Schacht entnehmen kann. Ein weiterer Stapel von Leiterplatten kann in den Schacht zu einem beliebigen Zeitpunkt ohne Unterbrechung der Zufuhr des obersten Stapels von Leiterplatten zur Leiterplattenabnahmeeinrichtung eingeführt und auf einem Satz von unterhalb angeordneten Auflageelementen abgelegt werden.

Die erfindungsgemäße Vereinzelungseinrichtung kann somit kontinuierlich betrieben werden, wobei die Vereinzelung beschädigungsfrei und konturunabhängig erfolgt.

Bei der Lösung nach Anspruch 15 wird eine Sammeleinrichtung vorgesehen, die einen über einer Fördereinrichtung angeordneten Schacht aufweist, der nach unten offen ist. Am unteren Ende des Schachts sind elastisch nachgebende Klinkenelemente vorgesehen, auf welchen ein Stapel von Leiterplatten aufliegt. Unter der Fördereinrichtung sind im Bereich unterhalb des Schachtes ein vertikal beweglicher Stempel und mehrere Stößel angeordnet. Dieser Stempel und diese Stößel können mit einer Hubbewegung die Fördereinrichtung nach oben durchgreifen, wobei eine über ihnen angeordnete Leiterplatte mitgenommen und in den Schacht befördert wird. Die elastischen Klinkenelemente geben bei der von unten kommenden Bewegung nach und weichen der Leiterplatte kurzzeitig aus, so daß die Leiterplatte beim Absenken des Stößels durch die zurückkommenden Klinkenelemente gehalten wird. Da mehrere Stößel vorgesehen sind, werden die Leiterplatten an mehreren Punkten verteilt unterstützt, so daß ein Durchbiegen der Leiterplatten während des Anhebens derselben verhindert wird.

Die Erfindung wird nachfolgend beispielhaft anhand der Zeichnungen näher erläutert. Es zeigen schematisch:
- Fig. 1: eine erfindungsgemäße automatisierte Vorrichtung zum Prüfen von Leiterplatten in einer schematisch sehr vereinfachten Draufsicht,
- Fig. 2: eine Vereinzelungseinrichtung der erfindungsgemäßen automatisierten Prüfvorrichtung in einer Draufsicht,
- Fig. 3: die in Fig. 2 gezeigte Vereinzelungseinrichtung in einer Seitenansicht,
- Fig. 4: die in Fig. 2 gezeigte Vereinzelungseinrichtung in einer Stirnseitenansicht,

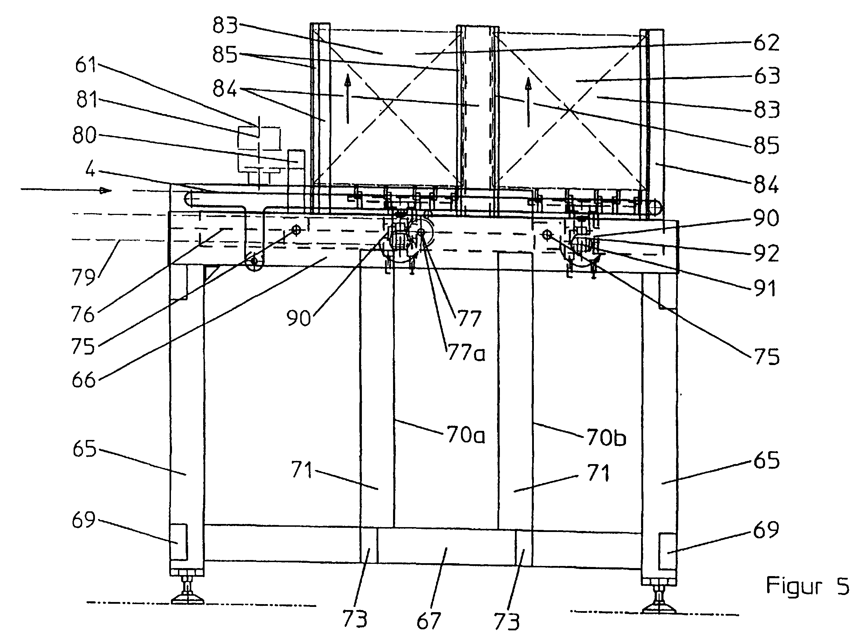

- Fig. 5: eine Sammeleinrichtung der erfindungsgemäßen automatisierten Prüfvorrichtung in einer Seitenansicht,
- Fig. 6: die in Fig. 5 gezeigte Sammeleinrichtung in einer Draufsicht,
- Fig. 7: die in Fig. 5 gezeigte Sammeleinrichtung in einer Stirnseitenansicht in Transportrichtung,
- Fig. 8a und 8b: schematisch vereinfacht eine Seiten- und Frontansicht einer Spindelhubeinrichtung zum Anheben der zu vereinzelnden Leiterplatten in der in Fig. 1 gezeigten Vereinzelungseinrichtung.

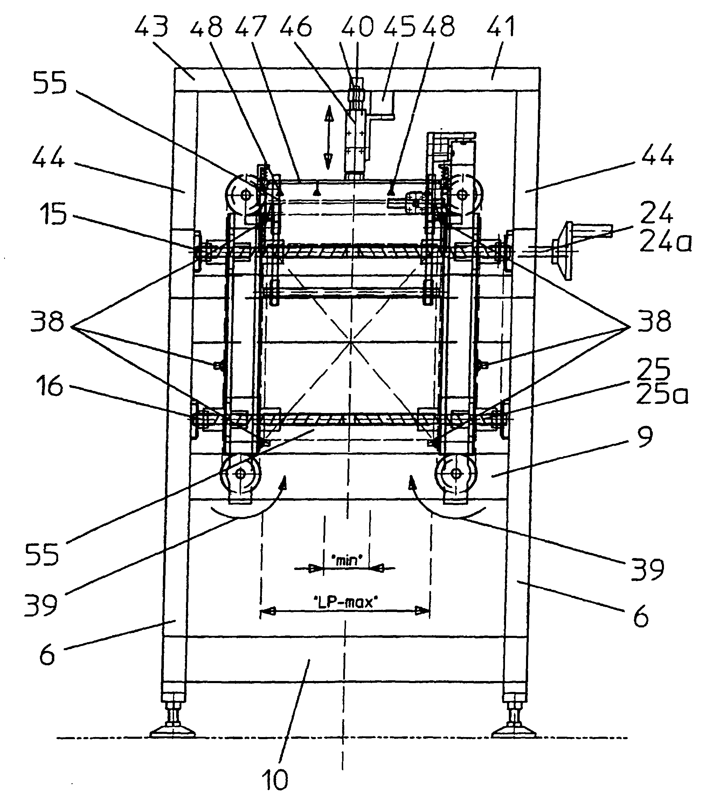

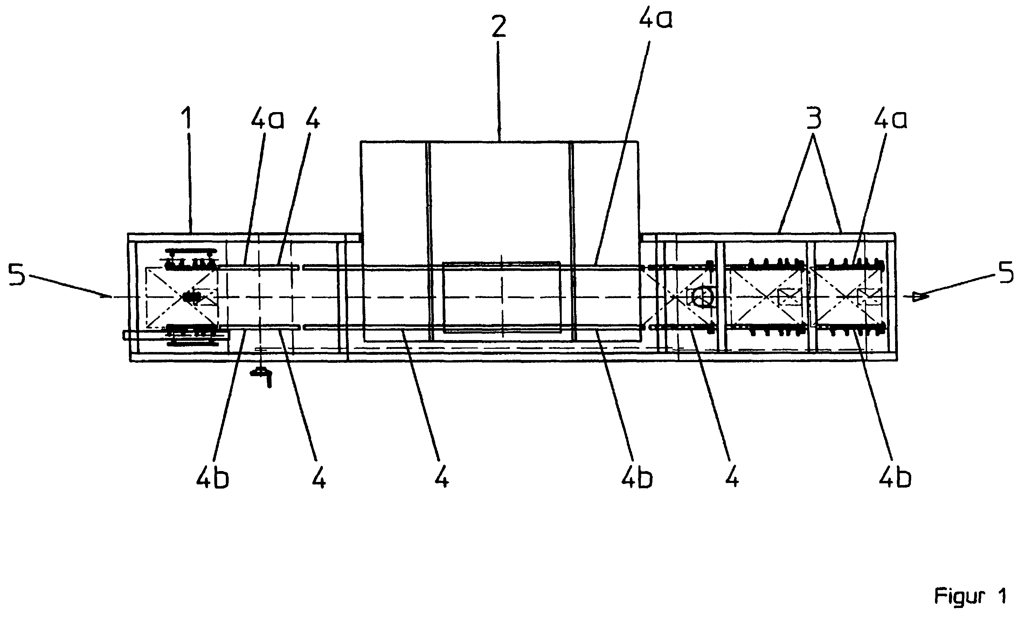

Die erfindungsgemäße automatisierte Vorrichtung zum Prüfen von Leiterplatten weist eine Vereinzelungseinrichtung 1, eine Prüfeinrichtung 2 und eine Sammeleinrichtung 3 auf (Fig. 1). Als Fördereinrichtung ist ein zweiteiliges Transportband 4 mit zwei einzelnen, parallel zueinander angeordneten Transportriemen 4a, 4b vorgesehen. Das Transportband 4 erstreckt sich von der Vereinzelungseinrichtung 1 über die Prüfeinrichtung 2 zur Sammeleinrichtung 3, wobei es in mehrere Längsabschnitte unterteilt sein kann. Das Transportband 4 bzw. deren Abschnitte werden von einer nicht dargestellten Antriebseinrichtung in Transportrichtung 5 bewegt, wobei vorzugsweise für die Vereinzelungseinrichtung 1, die Prüfeinrichtung 2 und die Sammeleinrichtung 3 jeweils eine separate Antriebseinrichtung vorgesehen ist, so daß in diesen einrichtungen 1, 2 und 3 die Leiterplatten unabhängig voneinander bewegt und positioniert werden können.

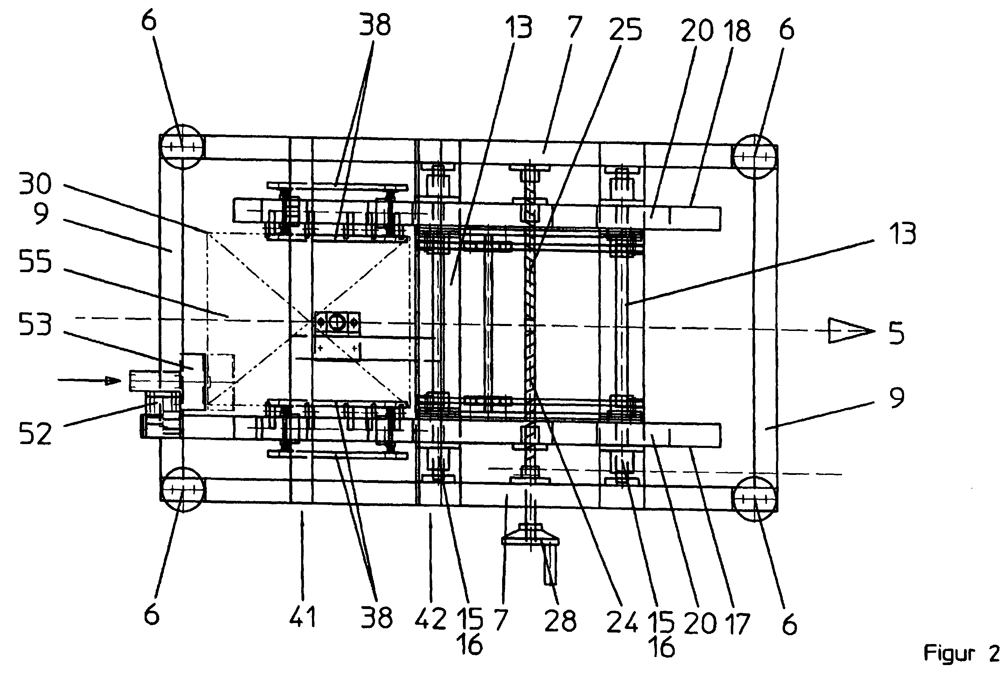

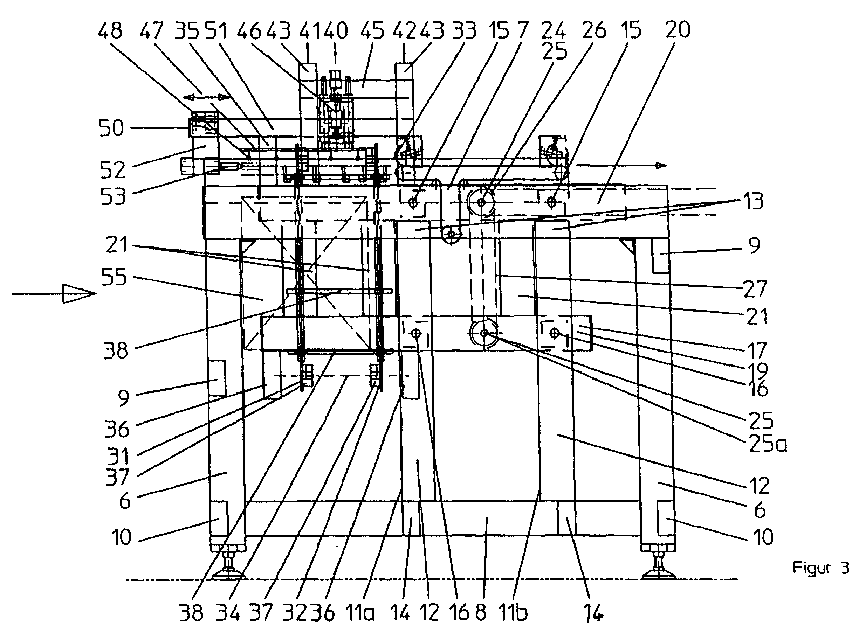

Die Vereinzelungseinrichtung 1 weist ein quaderförmiges Gestell mit vier vertikal ausgerichteten Eckträgern 6, zwei oberen Längsträgern 7, zwei unteren Längsträgern 8, zwei oberen Querträgern 9 und zwei unteren Querträgern 10 auf (Fig. 2 bis 4). An dem quaderförmigen Gestell sind zwei rechteckige Tragrahmen 11a, 11b befestigt, wobei ein jeder Tragrahmen aus zwei Vertikalträgern 12 und aus je einem oberen und unteren Horizontalträger 13, 14 besteht. Die Vertikalträgern 12 erstrecken sich jeweils zwischen einem oberen und einem unteren Längsträger 7,8 und die Horizontalträger 13, 14 zwischen den zwei oberen Längsträgern 7 bzw. zwischen den zwei unteren Längsträgern 8. Die oberen Horizontalträger 13 sind flache, im Querschnitt rechteckige Profile, die im Bereich der Unterkante der oberen Längsträger 7 befestigt sind. Oberhalb und parallel zu den Horizontalträgern 13 sind obere Führungsstangen 15 zwischen den oberen Längsträgern 7 befestigt. Unterhalb und parallel zu den oberen Führungsstangen 15 sind-untere Führungsstangen 16 angeordnet, die jeweils zwischen zwei Vertikalträger 12 befestigt sind.

An den Führungsstangen 15, 16 sind zwei Schlitten 17, 18 verschiebbar angeordnet. Jeder der beiden Schlitten 17, 18 weist einen unteren und einen oberen horizontalen Hauptträger 19, 20 auf, die mittels jeweils dreier vertikaler Verbindungsträger 21 mit den festen, ebenflächigen, vertikal ausgerichteten Schlitten 17, 18 verbunden sind.

Die Länge der Schlitten 17, 18 ist etwas kürzer als die Längserstreckung des Gestells, jedoch etwa doppelt so lang wie der Abstand zwischen den beiden Tragrahmen 11a, 11b. Die beiden Tragrahmen 11a, 11b sind in Transportrichtung der zu befördernden Leiterplatten im vorderen Bereich des Gestells angeordnet. Die Schlitten 17, 18 erstrecken sich mit ihrem in Transportrichtung 5 hinten angeordneten Bereich mit nicht ganz der Hälfte ihrer Länge über den rückwärtig angeordneten Tragrahmen 11a hinaus.

Die unteren und oberen Hauptträger 19, 20 der Schlitten 17, 18 werden im Bereich zwischen den Rahmen 11a, 11b von jeweils einer oberen und unteren Gewindestange 24, 25 durchgriffen, die quer zur Transportrichtung 5 ausgerichtet sind. In der Längsmitte der Gewindestangen 24, 25 wechselt das Gewinde von einem Rechts- in ein Linksgewinde, und die Gewindestangen greifen in entsprechende Gewindebohrungen 24a, 25a in den Hauptträgern 19, 20 ein. An einem seitlichen Bereich der Gewindestangen 24, 25 ist jeweils ein Zahnrad 26 angordnet, um das eine Kette 27 geführt ist, so daß die Drehung der beiden Gewindestangen 24, 25 synchronisiert ist. Die obere Gewindestange 24 ist durch einen der Längsträger 7 hindurch verlängert und außerhalb des Gestells mit einem Handrad 28 versehen.

Durch Drehen des Handrads 28 werden die beiden Gewindestangen 24, 25 in Drehbewegung versetzt, so daß die beiden auf den Führungsstangen 15, 16 gleitend geführten Schlitten 17, 18 aufeinander zu oder auseinander bewegt werden.

Am hinteren Bereich der beiden Schlitten 17, 18 ist ein erfindungsgemäßer Schacht 30 für die zu prüfenden Leiterplatten ausgebildet.

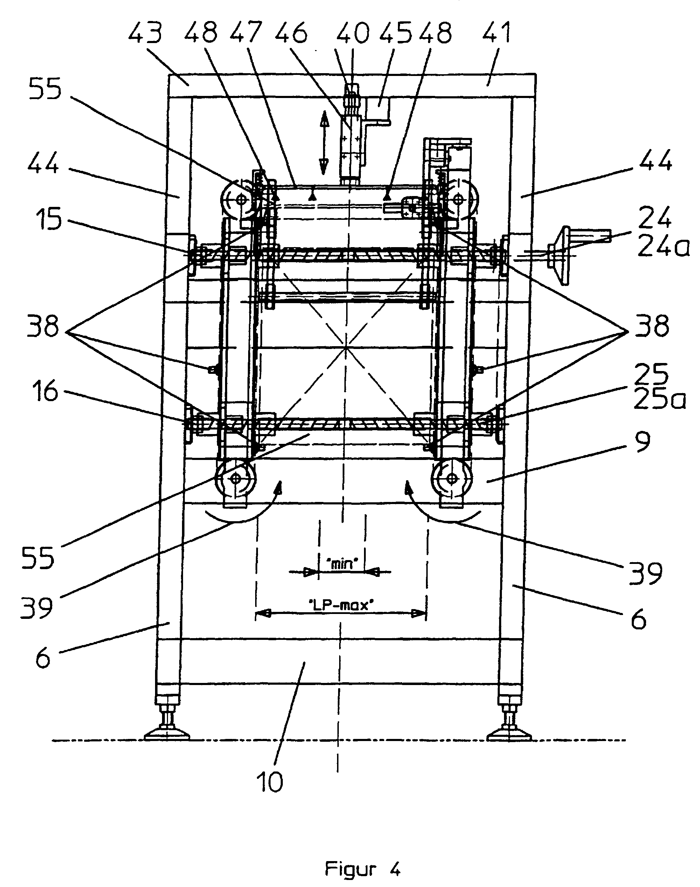

Dieser Schacht 30 wird seitlich von jeweils zwei um die hinteren Enden der Hauptträger 19, 20 verlaufenden Ketten 31, 32 begrenzt. Zur Führung der beiden Ketten 31, 32 ist jeweils eine Welle 33, 34 oberhalb des oberen Hauptträgers 20 bzw. unterhalb des unteren Hauptträgers 19 und parallel zu dem jeweiligen Hauptträger 19, 20 an oberen bzw. unteren Lagerblöcken 35, 36 gelagert. Auf den Wellen sind Zahnräder 37 angeordnet, um welche die Ketten 31, 32 geführt sind. Die Ketten 31, 32 eines Schlittens 17, 18 sind jeweils mit als Auflageelement dienenden Auflageleisten 38 verbunden. Die Auflageleisten 38 sind horizontal angeordnet, wobei die Auflageleisten 38 der beiden Schlitten 17, 18 im Schacht 30 paarweise auf gleicher Höhe gegenüberliegend angeordnet sind. Die Ketten 31, 32 werden durch eine nicht dargestellte Antriebseinrichtung so angetrieben, daß sich deren innen liegende Trumme nach oben (Pfeil 39) bewegen (Fig. 4).

Im Bereich oberhalb des Schachtes 30 ist eine als Leiterplattenabnahmeeinrichtung 40 dienende, an sich bekannte pick-and-place-Einrichtung angeordnet.

Die Leiterplattenabnahmeeinrichtung weist zwei in Transportrichtung 5 hintereinander angeordnete, U-förmige, nach unten offene Haltebrücken 41 ,42 mit jeweils einem Querträger 43 und zwei seitlichen Schenkeln 44 auf, die auf den Längsträgern 7 des Gestells befestigt sind. Zwischen den beiden Querträgern 43 ist mittig eine Längsschiene 45 befestigt, an der eine an sich bekannte Hubeinrichtung 46 befestigt ist. Diese Hubeinrichtung 46 ist üblicherweise ein pneumatisches Zylinder-/Kolbenelement, das sich von der Längsschiene nach unten bis kurz oberhalb des Schachtes 30 erstreckt. Am unteren Ende der Hubeinrichtung 46 ist eine horizontal angeordnete Saugerplatte 47 mit mehreren Saugelementen 48 befestigt. Diese Saugerplatte 47 kann mittels der Hubeinrichtung vertikal zwischen einer unteren und oberen Stellung auf- und abbewegt werden. Die Saugelemente 48 sind an sich bekannte, pneumatisch betätigbare Vakuumgeber.

Die Leiterplattenabnahmeeinrichtung 40 weist zudem eine Verschiebeeinrichtung 50 auf.

Die Verschiebeeinrichtung 50 ist an den oberen Lagerblöcken 35 eines der Schlitten 17, 18 befestigt, wobei die Lagerblöcke 35 etwas nach oben verlängert sind. Diese oberen Lagerblöcke 35 tragen an ihrem oberen Ende eine horizontale Führungsschiene 51, die sich vom rückwärtigen Ende des Gestells bis etwa zur Längsmitte des Gestells erstreckt. An dieser Führungsschiene 51 ist ein Schieber 52 mit einem horizontal angeordneten Greifelement 53 geführt. Der Schieber 52 ist auf dieser Führungsschiene mittels eines nicht dargestellten Motors verfahrbar. Der Schieber 52 ist in der Stirnseitenansicht (Fig. 4) etwa S-förmig, so daß er sich von oberhalb der Führungsschiene 51 nach unten erstreckt, so daß das Greifelement etwas unterhalb der Saugerplatte 47 in ihrer oberen Stellung angeordnet ist.

Nachfolgend wird der Betrieb der Vereinzelungseinrichtung beschrieben:

Der Schacht 30 ist zu der in Transportrichtung 5 rückwärtigen Stirnseite (Fig. 4) offen, so daß ein Stapel von Leiterplatten 55 zwischen die inneren Trumme der Ketten 31, 32 von Hand eingeführt und auf zwei sich gegenüberliegenden Auflageleisten 38 abgelegt werden kann. Der Stapel von Leiterplatten 55 wird dann nach oben angehoben, bis seine Oberkante eine vorbestimmte Höhe eingenommen hat, die von einem nicht dargestellten Sensor wahrgenommen wird.

Nun wird die Saugerplatte 47 auf die oberste Leiterplatte 55 des Stapels abgesenkt, und diese Leiterplatte 55 wird von den Saugelementen 48 angesaugt. Die Saugerplatte 47 wird zusammen mit der Leiterplatte 55 nach oben in ihre obere Stellung bewegt. Hier nimmt der Schieber 52, der sich in seiner rückwärtigen Stellung befindet, mit seinem Greifelement 53 die Leiterplatte 55 auf. Die Leiterplatte 55 wird von der Saugerplatte 47 gelöst und durch eine Bewegung des Schiebers 52 entlang der Führungsschiene 51 in Transportrichtung 5 befördert und auf dem Transportband 4 abgelegt, mit dem die Leiterplatte 55 zur Prüfeinrichtung 2 befördert wird. Der Schieber 52 wird zurück in seine rückwärtige Ausgangsposition gefahren und eine weitere Leiterplatte 55 mittels der Saugerplatte 47 vom Stapel aufgenommen.

Dieser Vorgang wird wiederholt durchgeführt, wobei jeweils eine Leiterplatte 55 vom Stapel vereinzelt und dem Transportband 4 zugeführt wird. Hierbei werden die Ketten 31, 32 des Schachtes 30 so angetrieben, daß die Leiterplatten 55 von unten nach oben allmählich nachgeführt werden, um so die Oberkante des Stapels von Leiterplatten 55 immer in vorbestimmter Höhe zu halten.

An den Ketten 31, 32 sind jeweils mehrere Auflageleisten 38 befestigt, so daß sich im Schacht 30 zumindest zwei Paare von gegenüberliegenden Auflageleisten 38 befinden können. Somit kann in den Schacht 30, wenn sich der im Vereinzelungsvorgang befindliche Stapel von Leiterplatten 55 zu Ende neigt, ein weiterer Stapel von Leiterplatten 55 in den Schacht 30 eingeführt und auf mit Abstand unter dem oberen Stapel angeordneten Auflageleisten 38 aufgelegt werden. Hierbei kann der Vereinzelungsvorgang zum Vereinzeln des oberen Stapels ohne Unterbrechung fortgeführt werden. Ist der obere Stapel vollständig vereinzelt, wird der untere Stapel nach oben befördert, so daß dessen oberste Leiterplatte 55 von der Leiterplattenaufnahmeeinrichtung 40 aufgenommen werden kann. Der Vorgang des Anhebens des unteren Stapels nach oben in der Vereinzelungsstellung erfolgt innerhalb der Taktzeit der Leiterplattenaufnahmeeinrichtung 40, so daß die Leiterplattenaufnahmeeinrichtung 40 ohne Unterbrechung kontinuierlich Leiterplatten 55 aus dem Schacht 30 entnehmen kann.

Die aus dem Schacht 30 entnommenen Leiterplatten 55 werden von der Verschiebeeinrichtung 50 auf dem Transportband 4 abgelegt und in Transportrichtung 5 zur Prüfeinrichtung 2 befördert. In der Prüfeinrichtung 2 werden die Leiterplatten 55 üblicherweise auf Kurzschlüsse und Unterbrechungen getestet. Nach dem Testvorgang werden die Leiterplatten 55 weiter zur Sammeleinrichtung 3 befördert, wobei sie ununterbrochen auf den Förderriemen 4a, 4b des Transportbandes 4 aufliegen.

Die Sammeleinrichtung 3 ist in drei in Transportrichtung 5 aufeinanderfolgend angeordnete Bereiche, den Markierbereich 61, den Sammelbereich 62 für fehlerhafte Leiterplatten - Sammelbereich schlecht - und den Sammelbereich 63 für fehlerfreie Leiterplatten - Sammelbereich gut - unterteilt.

Die Sammeleinrichtung weist wiederum ein quaderförmiges Gestell mit vier vertikal ausgerichteten Eckträgern 65, zwei oberen Längsträgern 66, zwei unteren Längsträgern 67, zwei oberen Querträgern 68 und zwei unteren Querträgern 69 auf. An dem quaderförmigen Gestell sind wiederum zwei Tragrahmen 70a, 70b befestigt, wobei ein jeder Tragrahmen 70a, 70b aus zwei Vertikalträgern 71 und aus je einem oberen und unteren Horizontalträger 72, 73 besteht. Die Vertikalträger 71 erstrecken sich jeweils zwischen einem oberen und einem unteren Längsträger 66, 67 und die Horizontalträger 72, 73 zwischen den zwei oberen Längsträgern 66 bzw. den zwei unteren Längsträgern 67.

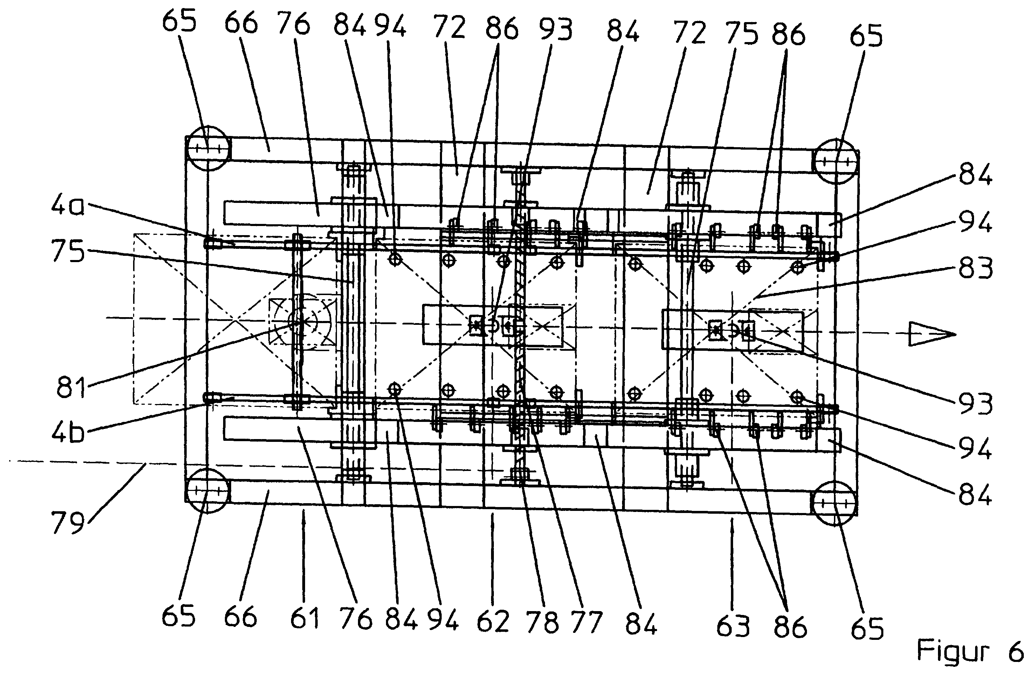

Zwischen den oberen Längsträgern 66 sind ähnlich wie bei der Vereinzelungseinrichtung 1 1 zwei Führungsstangen 75 quer zur Transportrichtung 5 angeordnet. An den Führungsstangen 75 sind zwei parallel zu den oberen Längsträgern 66 angeordnete Tragleisten 76 gelagert. An der Innenseite der Tragleisten 76 sind Führungsrollen für die Transportriemen 4a, 4b gelagert, wie es schematisch sehr vereinfacht in Fig. 6 gezeigt ist.

Die beiden Tragleisten 76 werden von einer quer zur Transportrichtung 5 angeordneten Gewindestange 77 durchgriffen, die parallel zu den Führungsstangen 75 ausgerichtet ist. In der Längsmitte der Gewindestange 77 wechselt das Gewinde von einem Rechts- in ein Linksgewinde, und die Gewindestange greift in entsprechende Gewindebohrungen 77a in den Tragleisten 76 ein. An einem seitlichen Bereich der Gewindestange 77 ist ein Zahnrad 78 angeordnet, um das eine Kette 79 geführt ist. Diese Kette 79 erstreckt sich bis zu der mit dem Handrad 28 versehenen Gewindestange 24 der Vereinzelungseinrichtung 1 und ist dort um ein weiteres Zahnrad (nicht dargestellt) geführt, so daß die Drehbewegung der Gewindestangen 24 und 77 zueinander synchronisiert sind. Hierdurch wird eine zentrale Verstellung der Spurweite des Transportbandes der Vereinzelungseinrichtung 1 als auch der Sammeleinrichtung 3 geschaffen. Vorzugsweise ist die Spurweite der Prüfeinrichtung entsprechend verstellbar ausgebildet und an die Kette 79 gekoppelt, so daß durch Drehen des Handrades 28 die Spurweite der gesamten automatisierten Vorrichtung zum Prüfen von Leiterplatten eingestellt wird.

In dem benachbart zur Prüfeinrichtung 2 angeordneten Markierbereich 61 der Sammeleinrichtung 3 ist ein nach unten offener U-förmiger Träger 80 angeordnet, der sich seitlich auf den oberen Längsträgern 66 abstützt. An dem Träger 80 ist eine an sich bekannte Markiereinrichtung 81 befestigt, die die Leiterplatten, die unter ihr hindurch befördert werden, in Abhängigkeit vom Prüfergebnis mit einer vorbestimmten Markierung versieht.

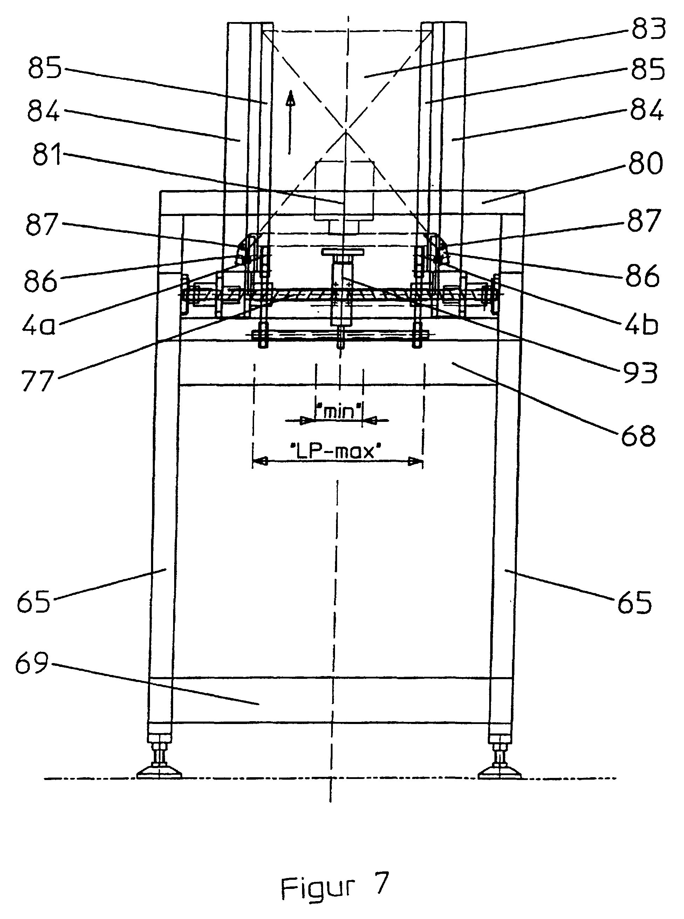

Die Sammelbereiche 62, 63 weisen jeweils einen im Querschnitt rechteckigen Sammelschacht 83 auf, der an seinen Ecken durch Säulen 84 begrenzt ist. Die Säulen 84 sind an der Oberseite der Tragleisten 76 befestigt und vertikal ausgerichtet. An den Säulen 84 sind Führungsleisten bzw. Führungsbleche 85 lösbar befestigt. Durch Austausch der Führungsleisten bzw. Führungsbleche 85 können die Sammelschächte 83 an die Form der Leiterplatten angepaßt werden. Zwischen den Säulen 84 sind mehrere Klinken 86 an den Tragleisten 76 befestigt, die mit jeweils einem schwenkbar gelagerten Klinkenarm 87 (Fig. 7) in den Schachtinnenbereich vorstehen und durch eine Feder vorgespannt sind, so daß beim Anheben einer Leiterplatte vom Transportband 4 die Klinkenarme 87 elastisch zurückweichen und ein Einschieben einer Leiterplatte von unten in den Sammelschacht 83 erlauben, wobei die Klinkenarme 87 selbsttätig wieder in den Schachtinnenbereich schwenken, so daß eine oder mehrere Leiterplatten im Sammelschacht 83 gehalten werden.

Zum Anheben der Leiterplatten ist jeweils eine Hebeeinrichtung 90 in den Sammelschächten im Bereich zwischen den Tragleisten 76 angeordnet. Diese Hebeeinrichtungen 90 weisen jeweils einen Elektromotor 91 auf, der eine Excenterscheibe 92 antreibt. Auf der Excenterscheibe 92 lagert ein horizontales Hebegestänge, das einen zentralen Stempel 93 als auch im Randbereich angeordnete Stößel 94 umfaßt. Durch eine Drehbewegung der Excenterscheibe 92 werden sowohl der zentrale Stempel 93 als auch die Stößel 94 angehoben, so daß eine Leiterplatte an mehreren über ihre Fläche verteilte Punkte unterstützt wird und beim Anheben die Leiterplatte nicht seitlich nach unten gebogen wird, selbst wenn ein Stapel von Leiterplatten auf ihr lasten sollte. Die Stößel lagern in Führungen, die an den Tragleisten 76 befestigt sind, so daß bei einer Verstellung der Spurweite der Sammeleinrichtung sich die Anordnung der Stößel 94 dementsprechend verstellt.

Die erfindungsgemäße Sammeleinrichtung unterstützt die Leiterplatten flächig, wodurch sie keinen Biegungen und damit auch keinen Beschädigungen unterliegen. Die Sammelschächte 83 sind vorzugsweise an einer Seite offen, bzw. die entsprechenden Führungsleisten bzw. Führungsbleche 85 sind aufklappbar ausgebildet, so daß die Sammelschächte 83 während des Betriebs entleert werden können. Hierdurch wird ein kontinuierlicher Betrieb der gesamten automatisierten Vorrichtung zum Prüfen von Leiterplatten ermöglicht.

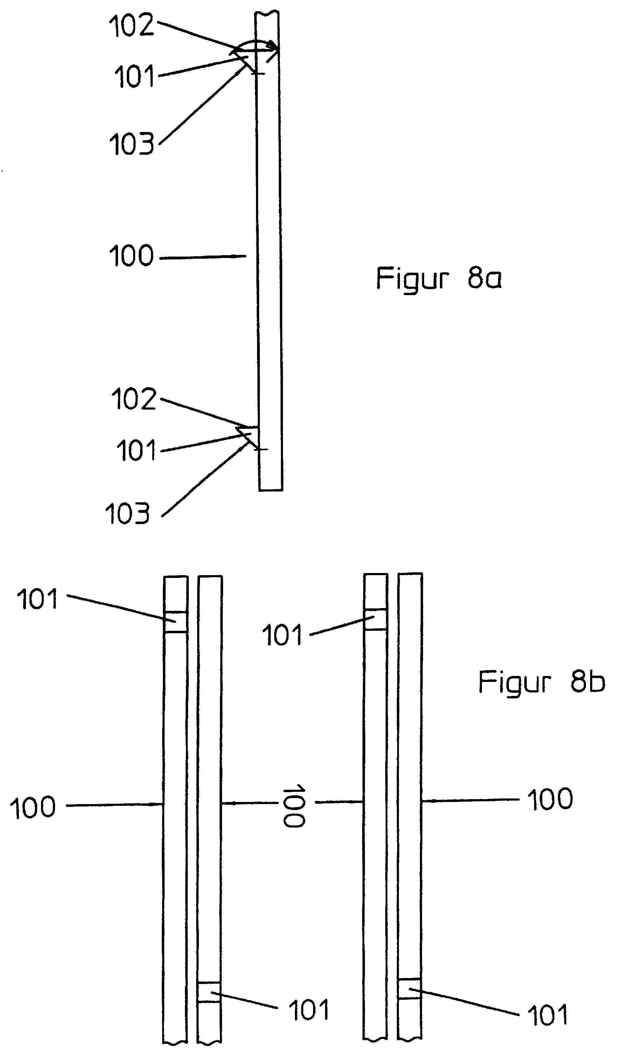

Die Erfindung ist nicht auf die im Ausführungsbeispiel erwähnten Transportmittel, wie die Ketten 31, 32 zum Anheben der zu vereinzelnden Leiterplatten, oder das Transportband 4, beschränkt. Anstatt der als Hubeinrichtungen dienenden Ketten 31, 32 zum Anheben der zu vereinzelnden Leiterplatten können auch Spindelhubeinrichtungen 100 (Fig. 8a, 8b) verwendet werden. Eine solche Spindelhubeinrichtung 100 weist eine vertikal angeordnete, drehbar angetriebene Spindel auf, die-ein nicht drehbares Hubelement durchgreift, das in der Spindel kämmend eingreift. Am Hubelement ist ein elastisch nachgebendes Auflageelement 101 befestigt, das mit einer oberen horizontalen Auflagekante 102 und einer unteren schräg angeordneten Gleitkante 103 ausgebildet ist. Die Spindelhubeinrichtungen 100 ragen jeweils mit ihren Auflageelementen 101 in den Innenbereich des Schachtes 30.

An jeder Seite des Schachtes sind jeweils zwei Paar der Spindelhubeinrichtungen 100 angeordnet, so daß der Schacht 30 insgesamt acht Spindelhubeinrichtungen 100 aufweist. Zum Drehen der Spindeln sind zwei Antriebseinheiten vorgesehen, wobei jede Antriebseinheit eine Spindel der paarweise angeordneten Spindelhubeinrichtungen antreibt. Es wird somit ein Satz von jeweils vier Auflageelementen 101 der vier Paare von Spindelhubeinrichtungen 100 synchron auf- bzw. abbewegt, wobei die Auflageelemente 101 eines solchen Satzes auf gleicher Höhe angeordnet sind. Auf jeden Satz von Auflageelementen 101 kann somit ein Stapel von Leiterplatten aufgelegt und nach oben befördert werden.

Ist ein Stapel von Leiterplatten vollständig vereinzelt, so wird der Satz von Auflageelementen 101 nach unten befördert, wobei diese durch ihre schräg angeordneten Gleitkanten 103 einem von unten durch den anderen Satz von Auflageelementen 101 nachgeführten Stapel von Leiterplatten federnd ausweichen und an dem Stapel vorbeigleiten. Dieser nach unten geführte Satz von Auflageelementen 101 kann dann wieder mit einem Stapel Leiterplatten beladen werden, während von dem anderen Satz von Auflageelementen 101 Leiterplatten vereinzelt werden. Die Leiterplattenaufnahmeeinrichtung 40 kann somit kontinuierlich von unten nachgeführte Leiterplatten aus dem Schacht 30 entnehmen.

## Patentansprüche

1. Automatisierte Vorrichtung zum Prüfen von Leiterplatten mit einer Vereinzelungseinrichtung (1), die einer Prüfeinrichtung vorgeordnet ist und die mittels einer Leiterplattenabnahmeeinrichtung (40), die oberhalb eines Schachtes (30) angeordnet ist, jeweils eine oberste Leiterplatte von einem im Schacht (30) befindlichen Stapel von Leiterplatten (55) abnimmt,
**dadurch gekennzeichnet,**
**daß** der Schacht (30) eine Hubeinrichtung mit zumindest zwei Sätzen von vertikal verfahrbaren Auflageelementen (38, 101) aufweist, die jeweils einen Stapel von Leiterplatten (55) tragen können, wobei der Schacht (30) zumindest an einer Seite offen ist, so daß ein Satz von Auflageelementen (38, 101) beladen werden kann, während ein auf dem anderen Satz von Auflageelementen (38, 101) lagernder Stapel von Leiterplatten (55) durch die Leiterplattenabnahmeeinrichtung (40) vereinzelt wird.

2. Vorrichtung nach Anspruch 1,
**dadurch gekennzeichnet,**
**daß** der Schacht (30) an zwei gegenüberliegenden Seiten von jeweils zwei vertikal geführten Ketten (31, 32) begrenzt ist, wobei die Ketten (31, 32) einer Seite jeweils mit als Auflageelement dienenden, horizontal angeordneten Auflageleisten (38) verbunden sind.

3. Vorrichtung nach Anspruch 2,
**dadurch gekennzeichnet,**
**daß** die Ketten (31, 32) einer Schachtseite umlaufend um eine obere Welle (33) und eine untere Welle (34) geführt sind.

4. Vorrichtung nach Anspruch 3,
**dadurch gekennzeichnet,**
**daß** eine Antriebseinrichtung zum Antreiben einer der beiden Wellen (33, 34) vorgesehen ist, die so ausgebildet ist, daß die Ketten (31, 32) mit ihren innenliegenden Trummen nach oben befördert werden, wobei vorzugsweise mindestens zwei unterschiedliche Geschwindigkeiten einstellbar sind.

5. Vorrichtung nach Anspruch 1,
**dadurch gekennzeichnet,**
**daß** die Hubeinrichtung mehrere Spindelhubeinrichtungen aufweist, die jeweils mit einer vertikal angeordneten, drehbar angetriebenen Spindel ausgebildet sind, die ein nicht drehbares Hubelement durchgreift, das in der Spindel kämmend eingreift.

6. Vorrichtung nach Anspruch 5,
**dadurch gekennzeichnet,**
**daß** am Hubelement ein elastisch nachgebendes Auflageelement (101) befestigt ist, das mit einer oberen horizontalen Auflagekante (102) und einer unteren schräg angeordneten Gleitkante (103) ausgebildet ist, wobei die Auflageelemente (101) jeweils in den Innenbereich des Schachtes (30) ragen.

7. Vorichtung nach Anspruch 6,
**dadurch gekennzeichnet,**
**daß** an jeder Seite des Schachtes (30) jeweils zwei Paar der Spindelhubeinrichtungen (100) angeordnet sind, so daß der Schacht (30) insgesamt acht Spindelhubeinrichtungen (100) aufweist.

8. Vorrichtung nach Anspruch 7,
**dadurch gekennzeichnet,**
**daß** eines der beiden Auflageelemente (101) eines jeden Paares der Spindelhubeinrichtungen (100) dem einen Satz von Auflageelementen (101) zugeordnet ist und das andere Auflageelement dem anderen Satz von Auflageelmenten (101) zugeordnet ist, wobei die Auflageelemente (101) eines Satzes jeweils in der gleichen Höhe angeordnet sind und gemeinsam auf- und abbewegt werden.

9. Vorrichtung nach einem der Ansprüche 1 bis 8,
**dadurch gekennzeichnet,**
**daß** die die Hubeinrichtung bildenden Elemente, wie z.B. die Ketten (31,32) bzw. die Spindelhubeinrichtungen (100), an zwei Schlitten (17,18) angeordnet sind, die zueinander verschiebbar gelagert sind.

10. Vorrichtung nach Anspruch 9,
**dadurch gekennzeichnet,**
**daß** die zwei Schlitten (17, 18) auf einer oder mehreren Führungsstangen (15, 16) lagern und von mindestens einer drehbar angeordneten Gewindestange (24, 25) durchgriffen werden, in deren Längsmitte das Gewinde von einem Rechtsin ein Linksgewinde wechselt, so daß die Schlitten (17, 18) beim Drehen der Gewindestange (24, 25) aufeinander zu oder voneinander weg bewegt werden.

11. Vorrichtung nach einem der Ansprüche 1 bis 10,
**dadurch gekennzeichnet,**
**daß** die Leiterplattenabnahmeeinrichtung (40) eine pick-and-place-Einrichtung ist.

12. Vorrichtung nach Anspruch 11,
**dadurch gekennzeichnet,**
**daß** die Leiterplattenabnahmeeinrichtung (40) eine vertikal ausgerichtete Hubeinrichtung (46) aufweist, an deren unterem Ende eine horizontal angeordnete Saugerplatte (47) mit mehreren Saugelementen (48) befestigt ist.

13. Vorrichtung nach Anspruch 12,
**dadurch gekennzeichnet,**
**daß** die Leiterplattenabnahmeeinrichtung (40) eine Verschiebeeinrichtung (50) zum horizontalen Verschieben der mit der Saugerplatte (47) aufgenommenen Leiterlatten aufweist.

14. Vorrichtung nach Anspruch 13,
**dadurch gekennzeichnet,**
**daß** die Verschiebeeinrichtung (50) einen horizontal verfahrbaren Schieber (52) aufweist, der mit einem Greifelement (53) versehen ist, so daß das Greifelement (53) eine Leiterplatte erfassen und durch eine Horizontalverschiebung auf einem Transportband (4) ablegen kann.

15. Automatisierte Vorrichtung zum Prüfen von Leiterplatten, nach einem der Ansprüche 1 bis 14, mit einer Sammeleinrichtung (3), die einer Prüfeinrichtung (2) nachgeordnet ist, die zumindest einen Sammelschacht (83) aufweist, in dem mittels einer Hebeeinrichtung (90) die geprüften Leiterplatten von unten eingeführt werden, wobei der Sammelschacht (83) mehrere Klinken (86) aufweist, hinter welchen die angehobenen Leiterplatten einrasten,
**dadurch gekennzeichnet,**
**daß** die Hebeeinrichtung (90) so ausgebildet ist, daß sie die Leiterplatten beim Anheben an mehreren über die Leiterplatten verteilten Punkten unterstützt.

16. Vorrichtung nach Anspruch 15,
**dadurch gekennzeichnet,**
**daß** die Hebeeinrichtung ein Hebegestänge mit einem zentralen Stempel (93) als auch mit im Randbereich der Leiterplatten angeordneten Stößel (94) zum Anheben der Leiterplatten umfaßt.

17. Vorrichtung nach Anspruch 16,
**dadurch gekennzeichnet,**
**daß** die Hebeeinrichtung (90) einen Elektromotor (91) aufweist, der eine Excenterscheibe (92) antreibt, die das Hebegestänge auf- und abbewegt.

18. Vorrichtung nach einem der Ansprüche 15 bis 17,
**dadurch gekennzeichnet,**
**daß** die Sammeleinrichtung zwei Sammelschächte (83) mit jeweils einer Hebeeinrichtung (90) aufweist.

19. Vorrichtung nach einem der Ansprüche 15 bis 18,
**dadurch gekennzeichnet,**
**daß** die Sammelschächte (83) zur Entnahme der darin gestapelten Leiterplatten an zumindest einer Seite offen ausgebildet sind.

20. Vorrichtung nach einem der Ansprüche 15 bis 19,
**dadurch gekennzeichnet,**
**daß** die den bzw. die Sammelschächte (83) begrenzenden Einrichtungen an zwei Tragleisten (76) befestigt sind, die auf einer oder mehreren Führungsstangen (75) lagern und von einer drehbar angeordneten Gewindestange (77) durchgriffen werden, in deren Längsmitte das Gewinde von einem Rechtsin ein Linksgewinde wechselt, so daß die Tragleisten (76) beim Drehen der Gewindestange (77) aufeinander zu oder voneinander weg bewegt werden.

21. Vorrichtung nach Anspruch 20,
**dadurch gekennzeichnet,**
**daß** an den Tragleisten Führungen für die Stößel (94) befestigt sind.

22. Vorrichtung nach Anspruch 10 und Anspruch 20 bzw. 21,
**dadurch gekennzeichnet,**
**daß** an einem seitlichen Bereich der Gewindestange (77) der sammeleinrichtung (3) ein Zahnrad (78) angeordnet ist, um das eine Kette (79) geführt ist, wobei sich diese Kette (79) bis zu der mit einem Handrad (28) versehenen Gewindestange (24) der Vereinzelungseinrichtung (1) erstreckt und dort um ein weiteres Zahnrad geführt ist, so daß die Drehbewegung der Gewindestangen (24 und 77) der Vereinzelungseinrichtng (1) und der Sammeleinrichtung (3) zueinander synchronisiert sind, wodurch eine zentrale Verstellung der Spurweite des-Transportbandes (4) der Vereinzelungseinrichtung (1) als auch der Sammeleinrichtung (3) erzielt wird.

## Claims

1. An automated circuit board tester comprising an unstacker (1) arranged upstream of a testing means and which by means of a circuit board picker (40) arranged above a chute (30) picks a topmost circuit board from a stack of circuit boards (55) located in the chute (30),
**characterised in that**
said chute (30) comprises a lifting means including at least two sets of vertically travelling supporting elements (38, 101), each of which is able to carry a stack of circuit boards (55), said chute (30) being open at least on one side so that a set of supporting elements (38, 101) can be loaded whilst a stack of circuit boards (55) located on said other set of supporting elements (38, 101) is unstacked by said circuit board picker (40).

2. The tester as set forth in claim 1,
**characterised in that**
said chute (30) is defined on two opposing sides by two vertically guided chains (31, 32) each, said chains (31, 32) of one side each being connected to horizontally disposed supporting slats (38) serving as a supporting element.

3. The tester as set forth in claim 2,
**characterised in that**
said chains (31, 32) of one chute side are guided circulating about an upper shaft (33) and a lower shaft (34).

4. The tester as set forth in claim 3,
**characterised in that**
a drive means for driving one of said two shafts (33, 34) is provided, said drive means being configured so that said chains (31, 32) are transported upwards by their runs located on the inside, preferably at least two different speeds being adjustable.

5. The tester as set forth in claim 1,
**characterised in that**
said lifting means comprise several spindle lifting means, each of which is configured with a vertical disposed, rotatably driven spindle passing through a non-rotatable lifting element mating said spindle.

6. The tester as set forth in claim 5,
**characterised in that**
secured to said lifting element is an elastically pliant supporting element (101) configured with an upper horizontal supporting edge (102) and a sliding edge (103) oriented slanting downwards, each spindle lifting means protruding by its supporting elements (101) into the interior region of said chute (30).

7. The tester as set forth in claim 6,
**characterised in that**
arranged on each side of said chute (30) are two pairs of spindle lifting means (100) so that in all said chute (30) features eight spindle lifting means (100).

8. The tester as set forth in claim 7,
**characterised in that**
one of said two supporting elements (101) of each pair of spindle lifting means (100) is assigned to one set of supporting elements (101) and said other supporting element is assigned to the other set of supporting elements (101), the supporting elements (101) of a set each being arranged level and moved up and down in common.

9. The tester as set forth in one of the claims 1 to 8,
**characterised in that**
the elements, such as e.g. said chains (31, 32) or said spindle lifting means (100) forming said lifting means are arranged on two slides (17, 18) mounted shiftable towards each other.

10. The tester as set forth in claim 9,
**characterised in that**
said two slides (17, 18) are mounted on one or more guide rods (15, 16) and passed through by at least one rotatably disposed threaded rod (24, 25) in the middle of which lengthwise the thread changes from a right-hand thread to a left-hand thread so that said slides (17, 18) are moved towards each other or away from each other on turning of said threaded rod (24, 25).

11. The tester as set forth in one of the claims 1 to 10,
**characterised in that**
said circuit board picker (40) is a pick-and-place means.

12. The tester as set forth in claim 11,
**characterised in that**
said circuit board picker (40) comprises a vertically oriented lifting means (46) at the lower end of which a horizontally disposed suction plate (47) having several suction elements (48) is secured.

13. The tester as set forth in claim 12,
**characterised in that**
said circuit board picker (40) comprises a shifting means (50) for horizontal shifting said circuit boards suctioned by said suction plate (47).

14. The tester as set forth in claim 13,
**characterised in that**
said shifting means (50) comprises a horizontally travelling pusher (52) provided with a gripper (53) so that said gripper is able to grip a circuit board and place it on a transport belt (4) by a horizontal shifting movement.

15. An automated circuit board tester as set forth in one of the claims 1 to 14 including a restacker (3) arranged downstream of a testing means (2), said restacker comprising at least one restacker chute (83) into which by means of a lifting means (90) said tested circuit boards can be introduced from underneath, said restacker chute (83) comprising several pawls (86) behind which said lifted circuit boards latch into place
**characterised in that**
said lifting means (90) is configured so that it supports said circuit boards at points distributed about said circuit boards on being lifted.

16. The tester as set forth in claim 15,
**characterised in that**
said lifting means comprises a lifting linkage having a central ram (93) as well as pushers (94) arranged in said edge portion of said circuit boards for lifting said circuit boards.

17. The tester as set forth in claim 16,
**characterised in that**
said lifting means (90) comprises an electric motor (91) driving a camplate (92), said camplate moving said lifting linkage up and down.

18. The tester as set forth in one of the claims 15 to 17,
**characterised in that**
said restacker comprises two restacker chutes (83) each having a lifting means (90).

19. The tester as set forth in one of the claims 15 to 18,
**characterised in that**
said restacker chutes (83) are configured open on at least one side for removing said circuit boards stacked therein.

20. The tester as set forth in one of the claims 15 to 19,
**characterised in that**
said means defining said restacker chute(s) (83) are secured to two supporting slats (76) mounted on one or more guide rods (75) and through which a rotatably disposed threaded rod (77) passes, in the middle of which lengthwise said thread changes from a right-hand thread to a left-hand thread so that said supporting slats (76) are moved towards each other or away from each other on turning of said threaded rod (77).

21. The tester as set forth in claim 20,
**characterised in that**
guides for said pushers (94) are secured to said supporting slats.

22. The tester as set forth in claim 10 and in claim 20 or 21, respectively,
**characterised in that**
disposed in each lateral portion of said threaded rod (77) of said restacker (3) is a sprocket (78) about which a chain (79) is guided, this chain (79) extending up to threaded rod (24) of said unstacker (1) being provided with a handwheel (28) where it is guided about a further sprocket so that the rotating movement of said guide rods (24, 77) of said unstacker (1) and said restacker (3) is in synchronism, as a result of which a central adjustment of the track width of said transport belt (4) of said unstacker (1) as well as of said restacker (3) is achieved.

## Revendications

1. Dispositif automatisé pour vérifier des cartes avec un dispositif d'isolation (1) qui est disposé en amont avec un dispositif de vérification et qui est disposé au moyen d'un dispositif de prélèvement des cartes (40) au dessus d'une cage (30) , la carte supérieure la plus en haut étant prélevée d'une pile de cartes (55) se trouvant dans la cage (30),
**caractérisé en ce que**,
la cage (30) comporte un dispositif de levage avec au moins deux jeux d'éléments de support (38, 101) susceptibles d'être conduit verticalement qui peuvent porter une pile de cartes (55) ; 'la cage (30) étant ouverte au moins sur un côté de manière à ce qu'un jeu d'éléments de support (38, 101) puisse être chargé pendant qu'une autre pile située sur l'autre jeu d'éléments de support (38, 101) de cartes (55) est isolée par le dispositif de prélèvement de cartes (40).

2. Dispositif selon la revendication 1,
**caractérisé en ce que**,
la cage (30) est limitée, à chaque fois, sur deux côtés se faisant face par deux chaînes (31, 32) conduites verticalement ; les chaînes (31, 32) étant reliées à un côté à chaque fois par des traverses de support (38) disposées horizontalement pour servir d'élément de support .

3. Dispositif selon la revendication 2 ,
**caractérisé en ce que**,
les chaînes (31, 32) d'un côté de la cage sont conduites de façon circonférentielle sur un arbre (33) supérieur et un arbre (34) inférieur.

4. Dispositif selon la revendication 3,
**caractérisé en ce que**,
un dispositif d'entraînement est prévu pour entraîner un des deux arbres (33, 34) qui est réalisé de manière à ce que les chaînes (31, 32) soient alimentées vers le haut avec leurs tambours situés à l'intérieur ; au moins deux vitesses différentes pouvant être réglées.

5. Dispositif selon la revendication 1,
**caractérisé en ce que**,
le dispositif de levage présente plusieurs dispositifs de levage par broche qui sont formés à chaque fois avec une broche entraînée de manière rotative et située de manière verticale, laquelle broche pénètre un élément de levage non rotatif qui pénètre comme un peigne dans la broche .

6. Dispositif selon la revendication 5,
**caractérisé en ce que**,
un élément de support (101) relâchant élastiquement est fixé sur l'élément de levage, lequel élément est formé par un bord de support supérieur et horizontal (102) et un bord de glissement (103) inférieur et disposé en biais ; les éléments de support (101) faisant saillie à chaque fois dans la zone intérieure de la cage (30).

7. Dispositif selon la revendication 6,
**caractérisé en ce que**,
sur chaque côté de la cage (30) deux paires des dispositifs de levage par broche (100) sont disposées à chaque fois de manière à ce que la cage (30) comporte en tout huit dispositifs de levage par broche (100).

8. Dispositif selon la revendication 7,
**caractérisé en ce que**,
un des deux éléments de support (101) d'une des paires de dispositifs de levage par broche (100) est associé à un jeu d'éléments de support (101) et **en ce que** l'autre élément de support est associé à l'autre jeu d'éléments de support (101) ; les éléments de support (101) d'un jeu étant disposés à la même hauteur et pouvant être bougés dans un mouvement de haut en bas .

9. Dispositif selon une des revendications 1 à 8,
**caractérisé en ce que**,
les éléments formant le dispositif de levage, comme par exemple, les chaînes (31, 32) ou les dispositifs de levage par broche (100) sont disposés sur les deux chariots (17, 18) qui peuvent être logés de manière à être susceptibles de se déplacer l'un par rapport à l'autre.

10. Dispositif selon la revendication 9,
**caractérisé en ce que**,
les deux chariots (17, 18) étaient placés sur une ou plusieurs tiges de conduite (15, 16) et étaient pénétrées par au moins une tige filetée (24, 25) disposée de manière rotative dans la moitié longitudinale de laquelle, le filetage change d'un filetage gauche vers un filetage droit de manière à ce que les chariots (17, 18) sont bougés l'un vers ou loin de l'autre lorsque la tige filetée (24, 25) est tournée.

11. Dispositif selon une des revendications 1 à 10,
**caractérisé en ce que**,
le dispositif de prélèvement des cartes (40) est un dispositif de « pick and « place « .

12. Dispositif selon la revendication 11,
**caractérisé en ce que**,
le dispositif de prélèvement de cartes (40) comporte un dispositif de levage (46) orienté verticalement sur l'extrémité inférieure duquel est fixée une plaque d'aspiration (47) disposée de manière horizontale au moyen de plusieurs éléments d'aspiration (48).

13. Dispositif selon la revendication 12,
**caractérisé en ce que**,
le dispositif de prélèvement de cartes (40) comporte un dispositif de déplacement (50) pour déplacer horizontalement les lattes d'échelle reçues par la plaque d'aspiration (47).

14. Dispositif selon la revendication 13,
**caractérisé en ce que**,
le dispositif de déplacement (50) comporte un poussoir (52) susceptible d'être conduit horizontalement qui est pourvu d'un élément de saisi (53) de manière à ce que l'élément de saisi (53) saisit une carte et peut la déposer par un déplacement horizontal sur une bande de transport (4).

15. Dispositif automatique pour vérifier des cartes selon une des revendications 1 à 14, avec un dispositif de collecte (3) qui est disposé en aval d'un dispositif de vérification (2) qui comporte au moins une cage de collecte (83) dans laquelle les cartes vérifiées sont introduites par le bas au moyen d'un dispositif de levage (90) ; la cage de collecte (83) comportant plusieurs cliquets (86) derrière lesquels les cartes levées s'encliquètent,
**caractérisé en ce que**,
le dispositif de levage (90) soit formé de manière à soutenir les cartes lors du levage à plusieurs endroits situés au dessus des cartes

16. Dispositif selon la revendication 15,
**caractérisé en ce que**,
le dispositif de levage comprend une tige de levage avec un tampon (93) central ainsi que des poussoirs (94) situés dans la zone des cartes pour lever les cartes .

17. Dispositif selon la revendication 16,
**caractérisé en ce que**,
le dispositif de levage (90) comporte un moteur électrique (91) qui entraîne un disque excentrique (92) qui bouge vers le haut et le bas les tiges de levage.

18. Dispositif selon une des revendications 15 à 17,
**caractérisé en ce que**,
le dispositif de collecte comporte deux cages de collecte (83) avec à chaque fois un dispositif de levage (90).

19. Dispositif selon une des revendications 15 à 18,
**caractérisé en ce que**,
les cages de collecte (83) pour enlever les cartes empilées à l'intérieur des cages sont réalisées sur au moins un côté de manière à rester ouvert .

20. Dispositif selon une des revendications 15 à 19,
**caractérisé en ce que**,
les dispositifs limitant les cages de collecte (83) sont fixés à deux traverses de portée (76) qui sont placées sur une ou plusieurs tiges de conduite (75) et sont traversés une tige filetée (77) disposée de manière rotative dans la moitié longitudinale de laquelle le filetage est changé d'un filetage gauche vers un filetage droite de manière à ce que les traverses de portée (76) soient bougées, en tournant la tige filetée (77), l'une vers ou loin de l'autre..

21. Dispositif selon la revendication 20,
**caractérisé en ce que**,
des guidages pour les poussoirs (94) sont fixés sur les traverses de portée .

22. Dispositif selon la revendication 10 et la revendication 20 ou 21,
**caractérisé en ce que**,
une roue dentée (78) est disposée sur une zone latérale de la tige filetée (77) du dispositif de collecte (3) pour pouvoir conduire une chaîne (79) ; cette chaîne (79) s'étendant jusqu'à la tige filetée (24) du dispositif de répartition (1) pourvu d'une roue à main (28) et étant conduite à cet endroit autour d'une autre roue dentée de manière à ce que le mouvement de rotation des tiges filetées (24 et 77) du dispositif d'isolation (1) et le dispositif de collecte (3) soient synchronisés l'un par rapport à l'autre ; un réglage central de la largeur de piste de la bande de transport (4) du dispositif d'isolation ainsi que du dispositif de collecte (3) étant obtenu.
